# EUROPEAN PATENT APPLICATION

(11) **EP 4 318 866 A1**
(43) Date of publication of application: **07.02.2024**
(21) Application number: 23184778.1
(22) Date of filing: 11.07.2023
(51) Int. Cl.: H02J 7/00

(54) **MODULAR CHARGING DEVICE AND COOLING STRUCTURE THEREOF**

(30) Priority: 28.07.2022 CN 202210899845
(71) Applicant: Techtronic Cordless GP, Anderson, SC 29621 (US)
(72) Inventor: LAI, Zhan Liang, Dongguan City (CN); YE, Wen Qiang, Dongguan City (CN)
(74) Representative: Novagraaf Group

(57) **Abstract**

The present invention discloses a modular charging device and a cooling structure thereof. The modular charging device comprises a housing, at least one battery package socket located on the housing, and a PCB located in the housing, the at least one battery package socket being located at one or two sides of the PCB, at least one battery package being electrically connectable into the at least one battery package socket in a plug-in manner, and the battery package socket comprising a battery package insertion slot extending inwards from the housing to the PCB. A cooling structure for a modular charging device comprises an air inlet disposed at one end of a housing, an air outlet at another end, and a pathway between a first PCB and a second PCB, the fan causing an airflow to flow through the pathway. Methods of controlling and using the modular charging device comprise: battery packages being controllable for charging either separately or in combination, and each battery package being removable from the housing for charging.

## Description

### TECHNICAL FIELD

The present invention relates to the field of electric tool charging, in particular to a modular charging device in which battery packages can be installed in a plug-in manner, a cooling structure thereof, and methods of controlling and using same.

### BACKGROUND ART

Cordless and other types of electric tools are powered to operate by, for example, detachable battery packs. When all of the power in the battery packs has been used up, they may be charged using a portable power supply device (e.g. a battery power station), such a charging method being advantageous when working in open country for example. Another type of plug-in electric tool may be connected to a power source using a power cord, etc., to obtain power for operation, and the power source may be the abovementioned power supply device.

Such a power supply device may be equipped with multiple battery packages, and comprises an inverter which converts the power of the battery packages to AC power, to power the electric tool or charge its battery pack. The battery packages are installed in the battery power station by means of a slide rail, and are connected to each other by leads. The battery power station further comprises a cooling system, wherein a louvre is arranged at one end of the battery power station as an air inlet and outlet, and a fan is located at the air inlet, drawing air from the outside environment into the battery power station; the air circulates inside the battery power station along a U-shaped path from the inlet, and then flows out through the outlet at the same end. The battery power station further comprises a control panel, on which are arranged multiple functional features, such as a switch button, an AC output panel, an AC output button, a circuit breaker, a Bluetooth button, an LED task indicator light, an LED task indicator light button, an LCD backlight button, a parallel port, etc.

### SUMMARY OF THE INVENTION

The present invention discloses a modular charging device, comprising a housing, at least one battery package socket located on the housing, and a PCB located in the housing, the at least one battery package socket being located at one or two sides of the PCB, at least one battery package being electrically connectable into the at least one battery package socket in a plug-in manner, and the battery package socket comprising a battery package insertion slot extending inwards from the housing to the PCB.

According to an embodiment of the present invention, each side of the PCB comprises at least one set of wiring lugs, the at least one battery package being correspondingly electrically connected to the at least one set of wiring lugs.

According to an embodiment of the present invention, the battery package insertion slot is a columnar insertion slot, and the battery package socket further comprises: a first sunken part, sunk inwards from the housing; and a second sunken part, sunk from the first sunken part to connect to the battery package insertion slot.

According to an embodiment of the present invention, each side of the PCB comprises at least one spring correspondingly electrically connected between the PCB and the at least one battery package.

According to an embodiment of the present invention, each of the at least one battery package comprises a columnar member, the columnar member comprising multiple electric terminals which are correspondingly electrically connected to each set of wiring lugs in the at least one set of wiring lugs.

According to an embodiment of the present invention, a second PCB spaced apart from the PCB is provided in the housing, the second PCB being provided with at least one hole for the battery package insertion slot to pass through.

According to an embodiment of the present invention, the modular charging device further comprises at least one slot disposed at the bottom of the housing, the at least one slot leading to the PCB.

According to an embodiment of the present invention, the modular charging device further comprises a control panel with a USB-C charging port provided thereon.

According to an embodiment of the present invention, each side of the PCB is electrically connected to the same number of battery packages.

According to an embodiment of the present invention, an inverter is mounted on the second PCB.

The present invention discloses a cooling structure for a modular charging device, the modular charging device comprising a housing, at least one battery package socket located on the housing, a fan, and a first PCB and a second PCB located in the housing, the cooling structure comprising an air inlet disposed at one end of the housing, an air outlet at another end, and a pathway between the first PCB and the second PCB, the fan causing an airflow to flow through the pathway.

According to an embodiment of the present invention, a high-heat-generating component is disposed in the pathway between the first PCB and the second PCB.

According to an embodiment of the present invention, a heat sink is provided on at least one of the first PCB and the second PCB, the heat sink being arranged perpendicular to the pathway.

According to an embodiment of the present invention, a heat sink is provided on at least one of the first PCB and the second PCB, the heat sink being arranged parallel to the pathway.

According to an embodiment of the present invention, the fan is disposed in the pathway, or disposed close to an outlet or inlet of the pathway.

According to an embodiment of the present invention, the housing has a sidewall disposed parallel to the first PCB and the second PCB, and another pathway formed between the first PCB and the sidewall and between the second PCB and the sidewall.

According to an embodiment of the present invention, the fan (41) causes an airflow to flow through the pathway and the other pathway.

In the modular charging device according to the present invention, through the modular arrangement and the cooling channel formed thereby, the structure of the modular charging device is optimized, and the assembly method, method of use and control method thereof are simplified, such that the cooling efficiency thereof is increased, thus lowering the production cost. In addition, by providing battery package sockets on the housing, plug-in connection of battery packages is realized, facilitating detachable fitting of battery packages to the modular charging device, making the structure of the modular charging device more compact, and making the modular charging device versatile.

### BRIEF DESCRIPTION OF THE DRAWINGS

Fig. 1 is a perspective drawing of a modular charging device according to the present invention.
Fig. 2 is a perspective drawing of battery package sockets of the housing of a modular charging device according to the present invention, with one battery package removed to show the battery package socket.
Fig. 3 is a sectional view of a modular charging device according to the present invention, showing the connections of battery packages and battery package sockets inside the housing.
Fig. 4 is a perspective drawing of the connections of battery packages of a modular charging device according to the present invention, with the housing removed.
Fig. 5 is a schematic drawing of a cooling structure of a modular charging device according to the present invention.
Reference labels: 100 - modular charging device; 101 - USB-C discharging port; 102 - USB-A discharging port; 103 - USB-C charging port; 104 - slot; housing - 110; 120 - battery package socket; 121 - battery package insertion slot; 122 - first sunken part; 123 - second sunken part; 20 - battery package; 21 - columnar member; 30 - PCB; 31 - inverter board; 32 - wiring lug; 33 - spring; 34 - hole; 40 - air intake mesh; 41 - fan; 42 - air exit window; 50 - heat sink.

### DETAILED DESCRIPTION OF THE INVENTION

Preferred embodiments of the present invention are described in further detail below with reference to the accompanying drawings. The description below is exemplary, and does not limit the present invention; any other similar scenarios also fall within the scope of protection of the present invention.

The present invention relates to a modular charging device 100, which is similar to a battery power station and comprises a housing 110 and a handle disposed above the housing 110. By means of the handle, the modular charging device 100 can be lifted and carried to a work site. Thus, the modular charging device 100 is portable, and can charge appliances (e.g. electric tools) and devices (e.g. batteries or battery packs) in need of charging at the work site.

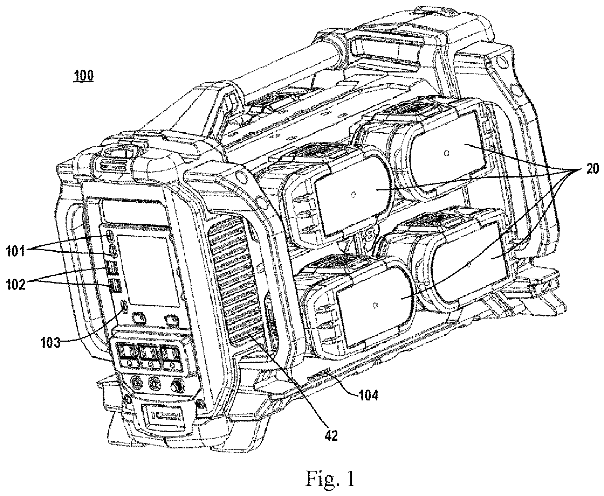

As shown in Fig. 1, one end of the housing of the modular charging device 100 comprises a control panel. USB-C discharging ports 101, USB-A discharging ports 102 and a USB-C charging port 103 are arranged on the control panel, in addition to conventional functional features. The USB-C charging port 103 can have a charging interface inserted therein to perform high-power, fast charging of a device to be charged. Of course, such charging may be charging of an appliance directly via a cable, or charging of a battery or battery pack of an appliance. In the present disclosure, in order to distinguish between the battery pack of the appliance itself and a battery assembly carried by the modular charging device 100, the battery assembly carried by the modular charging device 100 and used to charge another appliance is called a battery package. The battery package may be the same as the battery pack, or may have a larger charge capacity than the battery pack. The battery package may be a standard item, mass-produced to form a modular battery package, or may be an individual battery package custom-made according to a particular application. The power outputted by each battery package may for example be 300 W, 600 W or 1800 W. These powers may also be outputted by multiple battery packages in combination; for example, two 300 W battery packages could output 600 W, 6 300 W battery packages could output 1800 W, or 3 600 W battery packages could output 1800 W. The values of these powers are merely examples, and may be designed according to the particular application. The voltage of each battery package may also vary, e.g. 18 V

The voltage that the modular charging device 100 is capable of outputting by means of these battery packages can vary, e.g. 18 V, 120 V and voltages therebetween, or voltages of other values. Of course, the modular charging device 100 may also output lower voltages or powers via USB ports on the control panel; for example, a USB-C PD port realizes a power of 45 W, and a USB-A port realizes a power of 12 W or 18 W.

A slot 104 is provided on one side at the bottom of the housing, and a slot 104 may also be correspondingly provided on the other side, the slots 104 leading to a PCB 30 (also called a first PCB) described below. The slots 104 are generally used in notebook computers, being fixedly connected to internal memory strips. In the present disclosure, the slots 104 and the PCB 30 may be used as firmware plug connectors of the modular charging device 100; external electric connections may be connected to the PCB 30 via the slots 104 to update firmware.

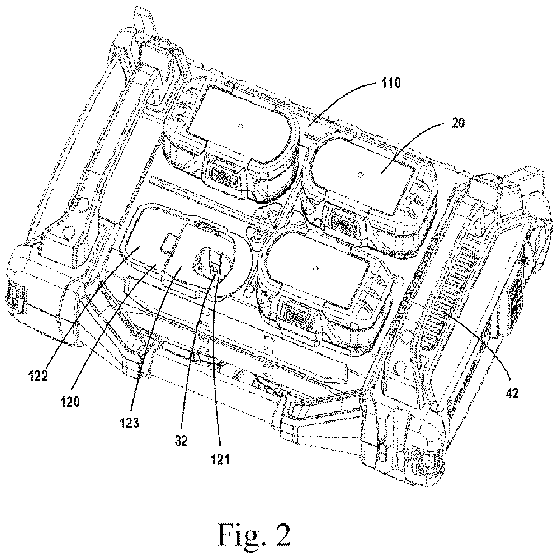

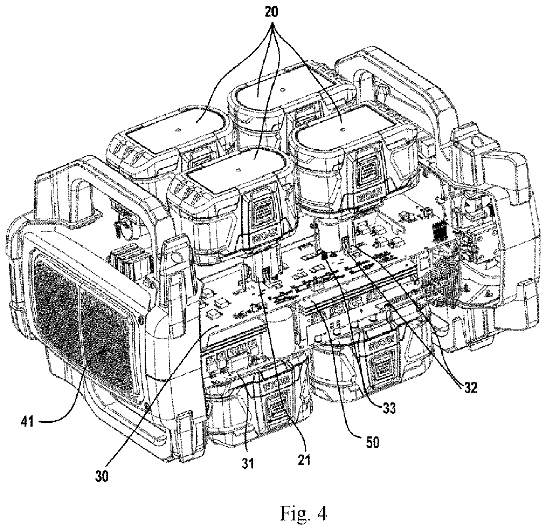

Referring to Figs. 1-4, the connections of battery packages 20 within the housing are described in detail below. The housing 110 may be formed of two identical half-housings. Thus, the housing may be symmetrical with respect to a mounting surface between the two half-housings. Of course, the housing could also have an asymmetric configuration. The PCB 30 is located in the housing, and may be located on the central symmetry plane of the housings, or be offset from the central symmetry plane. The housing has been removed in Fig. 4, to make it easier to view the connections and arrangement of the PCB and the battery packages. Only one side of the PCB is shown in the figure. Each side of the PCB 30 comprises at least one set of wiring lugs 32, e.g. 1 set, 2 sets, 3 sets, 4 sets, 5 sets or more. 4 sets are shown in the figure, but this is merely an example and non-limiting; other numbers of wiring lug sets may be provided according to the particular application. These wiring lug sets may be distributed uniformly or regularly on each side of the PCB 30, or may be distributed non-uniformly or irregularly, but are preferably distributed uniformly.

The two sides of the PCB 30 may have the same number of wiring lug sets or different numbers of wiring lug sets, and the wiring lug sets on the two sides may be arranged in a mirror-image fashion, i.e. arranged in one-to-one correspondence, or may be arranged completely or partially without correspondence, i.e. arranged irregularly and discretely, but are preferably arranged in a mirror-image fashion. Each set of wiring lugs 32 may comprise a positive pole wiring lug, a negative pole wiring lug and a ground wiring lug; these are respectively in contact with a positive pole electric terminal, a negative pole electric terminal and a ground electric terminal on the battery package 20 described below, and thus conduct power. The wiring lugs 32 may be metal spring lugs, which have a certain degree of elasticity and are thus tightly engaged with the corresponding electric terminals on the battery package 20, resisting a certain level of impact force. The wiring lugs 32 may be welded to the PCB 30.

In addition, a spring 33 is further provided on the PCB 30, one end of the spring 33 contacting a plating layer on the PCB 30 such as a tin-plating layer or silver-plating layer, and the other end being connected to the battery package 20 via a lead, thus serving as a signal terminal to detect and transmit electric signals of the battery package 20, e.g. whether the battery package 20 is connected to the PCB 30, whether the connection is secure, etc.

The battery package 20 and the wiring lugs 32 are shown as being electrically connected together in the figure. Although one or more sets of wiring lugs 32 are provided on each side of the PCB 30, it is not necessary for each set of wiring lugs 32 to be connected to a battery package 20, i.e. different numbers of battery packages 20 may be connected as needed. For example, different numbers of battery packages 20 may be connected to only one side of the PCB 30, e.g. a battery package 20 is connected to each of only 1, 2, 3, 4 or any number up to the total number of wiring lug sets 32. Of course, it is also possible for battery packages 20 to be connected to both sides of the PCB 30, and the number of battery packages 20 on each side may be the same or different; for example, there may be 1 battery package 20 on one side and 2 battery packages 20 on the other side, or 2 battery packages 20 may be connected to each of the two sides. Moreover, the battery packages 20 may be connected to the wiring lug sets 32 on the two sides of the PCB 30 completely or partially in a mirror-image fashion, or connected to the wiring lug sets 32 on the two sides of the PCB 30 completely or partially in a random fashion. Preferably, identical numbers of battery packages 20, e.g. 4 battery packages 20, are electrically connected to each side of the PCB 30. Preferably, identical numbers of battery packages 20 electrically connected to each side of the PCB 30 have mirror-image symmetry.

Each battery package 20 is shown in the figure as comprising a columnar member 21, the columnar member 21 comprising multiple electric terminals, the multiple electric terminals comprising the positive pole electric terminal, negative pole electric terminal and ground electric terminal as mentioned above; these electric terminals are electrically connected to each set of wiring lugs 32 in a corresponding fashion. Of course, the battery packages 20 may have other, different structures; moreover, battery packages 20 of one identical structure may be electrically connected to one side of the PCB 30, while battery packages 20 of another identical structure are electrically connected to the other side of the PCB 30; or battery packages 20 of one identical structure may be electrically connected to both sides of the PCB 30; or battery packages 20 of one identical structure may be electrically connected to one side, while battery packages 20 of two or more different structures are electrically connected to the other side; or battery packages 20 of two or more different structures may be electrically connected to both sides of the PCB 30.

To facilitate connection of the battery packages 20 to the PCB 30, a certain number of battery package sockets 120 are provided on the housing 110. The overall shape of the battery package sockets 120 corresponds to the shape and structure of the battery packages 20, and the battery package sockets 120 may be located on one side or both sides of the PCB 30, and may be in one-to-one correspondence with the number and arrangement of the wiring lugs 32. The battery package socket 120 comprises: a battery package insertion slot 121, extending into the housing and being close to or in abutment with the PCB 30; a first sunken part 122, sunk from the housing towards the interior of the housing; and a second sunken part 123, sunk from the first sunken part 122 further towards the interior of the housing. The first sunken part 122, the second sunken part 123 and the battery package insertion slot 121 are in communication with each other. The battery package insertion slot 121 and the columnar member 21 of the battery package 20 have corresponding shapes, and the wiring lugs 32 can enter the battery package insertion slot 121 through a sidewall of the battery package insertion slot 121, so as to be electrically connected to the electric terminals of the inserted battery package 20; moreover, the number and positions of the insertion slots 121 correspond to the number and positions of the wiring lug sets 32 on each side of the PCB 30. The battery package 20 and the columnar member 21 can be inserted into the housing via the elongated insertion slot 121 disposed on the housing, and be electrically connected to the wiring lug set 32 on the PCB 30. The battery package socket 120 and the insertion slot 121 can be used to support the battery package 20, and can also make it easier to insert and pull out the battery package 20, i.e. they make the battery package 20 detachable. The configuration and arrangement of the battery package sockets 120 shown in the figure are merely exemplary and non-limiting, and may be adjusted according to the particular configuration and arrangement of the battery packages. In addition, the battery package socket 120 may be formed integrally with the housing; in this way, manufacture is possible using just one mould.

In the housing, a second PCB 31 is provided at one side of the PCB 30, and spaced apart therefrom; an inverter is mounted on the second PCB 31, to subject the battery package 20 to relevant operations and adjustments, so the second PCB 31 may also be given the abbreviation of inverter board 31, and other electronic devices or power devices may also be mounted on the inverter board 31. Holes 34 are provided in the inverter board 31; the number and positions of these holes 34 correspond to the number and positions of the wiring lug sets on the corresponding side of the PCB, and allow the battery package sockets 120 of the housing and the insertion slots 121 thereof to pass through.

By means of the structure described above, for example the PCB 30, the wiring lug sets 32, the battery package sockets 120 of the housing 110 and the insertion slots 121 thereof, a larger number of battery packages 20 can be arranged on both sides of the PCB 30 in comparison with existing designs; in this way, it is possible to save space and increase the energy density of the battery packages and the modular charging device. In addition, the configuration of the battery package sockets 120 realizes plug-in connection of the battery packages 20, portable and detachable fitting of the battery packages 20 to the modular charging device 100, and compact design of the modular charging device 100. It must be pointed out that the modular charging device 100 realizes a versatile design by means of the battery package sockets 120, i.e. the battery package sockets 120 may be provided in any configuration and shape to suit various types of battery packages.

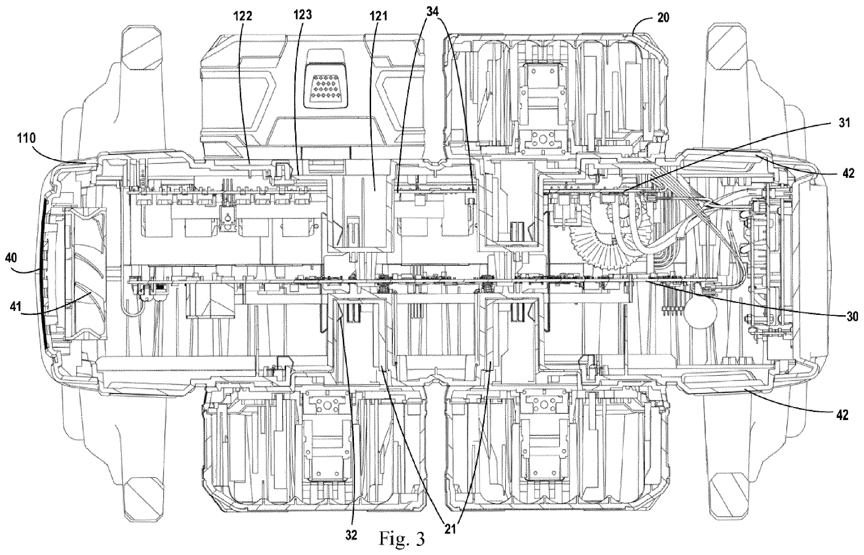

A cooling structure that may for example be used for the modular charging device 100 is described below with reference to Figs. 3-5, but is not limited to this; such a cooling structure may likewise be used on other types of charging devices.

The cooling structure comprises an air inlet disposed at one end of the housing and an air outlet at another end, and a pathway between the first PCB 30 and the second PCB 31. For example, the air outlet is located at the end where the control panel is located, and the air inlet is located at the opposite end. In this way, it is possible to avoid conflict between the air inlet and the control panel, e.g. conflict in the arrangement positions caused by space limitations, and it is thus possible to make the control panel larger, to add a greater number of functional features.

The air inlet comprises at least one air intake mesh 40, and at least one fan 41 disposed in the housing close to the at least one air intake mesh 40. Two air intake meshes and two fans are shown in the figures, but this is merely an example; other numbers of air intake meshes and fans may be provided according to the particular application, the dimensions of the modular charging device 100 and the cooling demands. The air intake mesh may be a metal material or another material, e.g. plastic. The air intake mesh is used to filter impurities and debris from the air, so that clean air enters the housing. The air intake mesh comprises mesh holes, the size and density of which may be set according to the application scenario. For example, when the air contains more debris, the mesh holes may be configured to be smaller and more densely spaced; when the air is cleaner, the mesh holes may be configured to be larger and less densely spaced. Alternatively, two or more air intake meshes with mesh holes of different sizes and densities may be provided, and switched and selected for use as the application scenario changes. In addition, each fan 41 may be disposed at two sides of the PCB 30 centrally and symmetrically with respect to the PCB 30, such that an airflow drawn by each fan is evenly split between the two sides of the PCB 30. Alternatively, the position of the fan 41 relative to the PCB 30 may be configured according to the energy densities at the two sides of the PCB 30; when the energy density at one side is greater, a larger portion of the fan 41 may be disposed at that side, such that a larger portion of the drawn airflow can flow past the battery package on that side, accelerating heat dissipation at that side. For example, more power devices are provided on the inverter board 31, these power devices generating a large amount of heat and therefore also being called high-heat-generating components; for this reason, the fan 41 may be offset towards the inverter board 31, so that a larger portion of the airflow drawn by the fan 41 can flow past the inverter board 31 and the power devices disposed thereon, so as to carry away more of the heat of these power devices more quickly. In addition, high-heat-generating components may also be disposed at other positions in addition to the second PCB 31, for example, disposed on the first PCB 30, or disposed at any position in the pathway between the first PCB 30 and the second PCB 31.

In addition, to accelerate and enhance heat dissipation in the housing, e.g. accelerate and enhance heat dissipation from the first PCB 30, the second PCB 31 and the high-heat-generating components, at least one heat sink 50 may be provided on either one, or both, of the first PCB 30 and the second PCB 31. For example, see Fig. 4, which shows an example of the heat sink 50. The heat sink 50 may be disposed close to the high-heat-generating components, or disposed at any suitable position in the housing as required, and the number of heat sinks 50 may be configured according to actual heat dissipation requirements; all that is needed is that they be able to accelerate and enhance heat dissipation. The heat sink 50 may have any shape, e.g. "L" shaped or inverted "L" shaped, "1" shaped, "T" shaped or inverted "T" shaped. For example, the heat sink 50 may be disposed on either one of the first PCB 30 and the second PCB 31, perpendicular to the pathway between the first PCB 30 and the second PCB 31; moreover, a main body part of the "1" shape of the heat sink for example is disposed perpendicular to the PCB, and one or more plate-like fins may extend in a protruding fashion from either side or both sides of the main body part of the "1" shape. Each fin may be a complete plate, or may be formed of a number of separate plate pieces, and the plate-like fins may be disposed parallel to the pathway between the first PCB 30 and the second PCB 31. This is merely an example, and there is no limitation to this; heat sinks 50 of various shapes may be entirely or partially disposed perpendicular or parallel to the pathway between the first PCB 30 and the second PCB 31.

In addition, to enhance heat dissipation in the housing, one or more fans 41 may be directly disposed at any suitable position in the pathway between the first PCB 30 and the second PCB 31, and/or may be disposed at the outlet or inlet of the pathway between the first PCB 30 and the second PCB 31, e.g. disposed at or near the air inlet at one end of the housing and/or the air outlet at the other end.

Furthermore, in addition to the pathway between the first PCB 30 and the second PCB 31, the housing also has a sidewall (e.g. two parallel sidewalls) parallel to the first PCB 30 and the second PCB 31, and another pathway formed between the first PCB and the sidewall and between the second PCB and the sidewall. That is, within the space of the housing, three mutually parallel pathways for example are formed sequentially between the two PCBs and two sidewalls of the housing which are parallel to the PCBs (and possibly also two other sidewalls, e.g. two sidewalls at the air inlet at one end of the housing and the air outlet at the other end). The pathway between the first PCB 30 and the second PCB 31 and the other pathways are in communication with each other in the housing, and the fan 41 causes an airflow to flow through the pathway between the first PCB 30 and the second PCB 31 and the other pathways. In this way, the interior space of the whole housing is ventilated to dissipate heat, and the housing and the components therein are cooled uniformly, efficiently and quickly.

Fig. 1 shows the air outlet as comprising an air exit window 42 disposed at one side of the housing 110. Of course, as shown in Fig. 3, it is also possible for an air exit window 42 to be provided at each of two sides of the housing; two air exit windows can accelerate the discharge of airflow, accelerating air circulation, to dissipate heat from the battery package more quickly. The air exit window 42 may be a louvre; such a structure is simple, with a good ventilation effect.

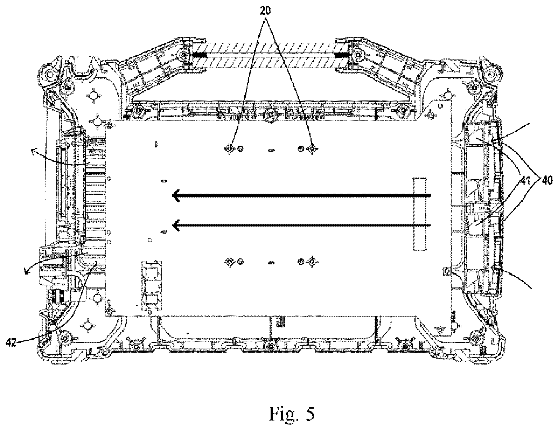

By arranging the air inlet and the air outlet at two ends of the housing, a direct and non-tortuous air cooling channel is formed, thus increasing the quantity and speed of airflow circulation. In Fig. 5, the positions of the battery packages are indicated schematically with the label 20. It can be seen that compared with the case where the air inlet and air outlet are disposed at the same end of the housing, air flows in and out more smoothly, and is thus able to carry away more of the heat generated by the battery packages when passing the battery packages; consequently, the cooling efficiency is greatly increased, and the heat dissipation result is excellent.

Methods of controlling and using the modular charging device 100 are described below. Since the battery packages are easy to plug into and pull out of the housing, modularity and detachability are realized, and the battery packages can be controlled and used independently of each other. In other words, the battery packages 20 can be controlled for charging separately or in combination, and each battery package 20 can be removed from the housing for charging. For example, while using an electric tool with its own battery pack, when the charge in the battery pack is insufficient or used up, a battery package with a suitable charge level (e.g. sufficient charge) can be directly pulled out of the modular charging device 100 and installed in the electric tool for use.

In addition, when charging an electric tool, etc., a battery package may be selected for charging according to the states of charge of the battery packages. For example, any battery package with sufficient charge may be selected directly, or a battery package with the optimal charge level may be selected, wherein "optimal charge level" means that the charge level of the battery package matches the charging requirement of the electric tool precisely or nearly perfectly. It is also possible to select different numbers of battery packages for charging according to the charging requirement. For example, depending on the charging requirement, one battery package meeting the requirement (i.e. with sufficient charge) may be selected directly for charging, or multiple battery packages with sufficient combined charge (i.e. total charge) may be selected for charging (e.g. when the charge levels of some or all of the battery packages are insufficient). Of course, when the charge levels of all or some of the battery packages are sufficient, it is also possible to select these battery packages with sufficient charge levels for combined use in charging; in this way, the charge consumption of each battery package can be balanced. The above description merely sets out a few examples of methods of control and use, and is not exhaustive; other control methods used in the art for battery package charging are included in the concept and protection scope of the present invention.

In the modular charging device according to the present invention, through the modular arrangement and the cooling channel thereby formed, the structure of the modular charging device is optimized, and the assembly method, method of use and control method thereof are simplified, such that the cooling efficiency thereof is increased, thus lowering the production cost. In addition, by providing battery package sockets on the housing, plug-in connection of battery packages is realized, facilitating detachable fitting of battery packages to the modular charging device, making the structure of the modular charging device more compact, and making the modular charging device versatile.

Although particular embodiments of the present invention have been described above, those skilled in the art should understand that these are merely exemplary explanations, and the scope of protection of the present invention is defined by the attached claims. Those skilled in the art could combine, change or modify these embodiments in various ways without departing from the principle and substance of the present invention, but all such combinations, change and modifications fall within the scope of protection of the present invention.

## Claims

1. Modular charging device (100), comprising a housing (110), at least one battery package socket (120) located on the housing (110), and a PCB (30) located in the housing (110), the at least one battery package socket (120) being located at one or two sides of the PCB (30), at least one battery package (20) being electrically connectable into the at least one battery package socket (120) in a plug-in manner, and the battery package socket (120) comprising a battery package insertion slot (121) extending inwards from the housing (110) to the PCB (30).

2. Modular charging device (100) according to Claim 1, wherein each side of the PCB (30) comprises at least one set of wiring lugs (32), the at least one battery package (20) being correspondingly electrically connected to the at least one set of wiring lugs (32).

3. Modular charging device (100) according to Claim 2, wherein the battery package insertion slot (121) is a columnar insertion slot, and the battery package socket (120) further comprises: a first sunken part (122), sunk inwards from the housing (110); and a second sunken part (123), sunk from the first sunken part (122) to connect to the battery package insertion slot (121).

4. Modular charging device (100) according to Claim 1, wherein each side of the PCB (30) comprises at least one spring (33) correspondingly electrically connected between the PCB (30) and the at least one battery package (20).

5. Modular charging device (100) according to Claim 2, wherein each of the at least one battery package (20) comprises a columnar member (21), the columnar member (21) comprising multiple electric terminals which are correspondingly electrically connected to each set of wiring lugs (32) in the at least one set of wiring lugs (32).

6. Modular charging device (100) according to Claim 1, wherein a second PCB (31) spaced apart from the PCB (30) is provided in the housing, the second PCB (31) being provided with at least one hole (34) for the battery package insertion slot (121) to pass through.

7. Modular charging device (100) according to Claim 1, further comprising at least one slot (104) disposed at the bottom of the housing, the at least one slot (104) leading to the PCB (30).

8. Modular charging device (100) according to Claim 1, wherein each side of the PCB (30) is electrically connected to the same number of battery packages (20).

9. Cooling structure for a modular charging device (100), the modular charging device (100) comprising a housing (110), at least one battery package socket (120) located on the housing (110), a fan, and a first PCB (30) and a second PCB (31) located in the housing (110), the cooling structure comprising an air inlet disposed at one end of the housing, an air outlet at another end, and a pathway between the first PCB (30) and the second PCB (31), the fan causing an airflow to flow through the pathway.

10. Cooling structure according to Claim 9, wherein a high-heat-generating component is disposed in the pathway between the first PCB (30) and the second PCB (31).

11. Cooling structure according to Claim 9, wherein a heat sink is provided on at least one of the first PCB (30) and the second PCB (31), the heat sink being arranged perpendicular to the pathway.

12. Cooling structure according to any one of Claims 9 - 11, wherein a heat sink is provided on at least one of the first PCB (30) and the second PCB (31), the heat sink being arranged parallel to the pathway.

13. Cooling structure according to any one of Claims 9 - 11, wherein the fan is disposed in the pathway, or disposed close to an outlet or inlet of the pathway.

14. Cooling structure according to any one of Claims 9 - 11, wherein the housing (110) has a sidewall disposed parallel to the first PCB (30) and the second PCB (31), and another pathway formed between the first PCB and the sidewall and between the second PCB and the sidewall.

15. Cooling structure according to Claim 14, wherein the fan (41) causes an airflow to flow through the pathway and the other pathway.
